# EUROPEAN PATENT APPLICATION

(11) **EP 4 753 398 A1**
(43) Date of publication of application: **03.06.2026**
(21) Application number: 25218174.8
(22) Date of filing: 25.11.2025
(51) Int. Cl.: H10D 1/00, H10D 1/68, H10D 1/66, H10D 84/00

(54) **SEMICONDUCTOR DEVICE AND METHOD OF FORMING THE SAME**

(30) Priority: 29.11.2024 CN 202411747497
(71) Applicant: GigaDevice Semiconductor (Shanghai) Inc., Shanghai 201210 (CN); GigaDevice Semiconductor Inc., Haidian, Beijing 100094 (CN); GIGADEVICE SEMICONDUCTOR (HEFEI) INC., Hefei Anhui 230601 (CN)
(72) Inventor: QIAN, Meng, Shanghai, 201210 (CN); LI, Xiaokang, Shanghai, 201210 (CN); XU, Yisheng, Shanghai, 201210 (CN); LUO, Xiao, Shanghai, 201210 (CN); FENG, Jun, Shanghai, 201210 (CN)
(74) Representative: Berggren Oy

(57) **Abstract**

A semiconductor device (100) includes a substrate (1), a plurality of first electrode structures (20), a second electrode structure (30), and a first dielectric layer (41). The substrate (1) has a capacitor region (12). The first electrode structures (20) are disposed on a surface of the substrate (1) in the capacitor region (12) and arranged at intervals in a first direction (X). The second electrode structure (30) is disposed on side surfaces (21) and a top surface (22) of each of the first electrode structures (20). The first dielectric layer (41) is disposed between the second electrode structure (30) and each of the first electrode structures (20).

## Description

### CROSS-REFERENCE TO RELATED APPLICATION

This application claims priority to Chinese Patent Application No. 202411747497.3, filed on November 29, 2024. The disclosure of the abovementioned application is incorporated herein by reference in its entirety.

### TECHNICAL FIELD

The present disclosure relates generally to semiconductor technologies, and in particular to a semiconductor device and a method of forming the semiconductor device.

### BACKGROUND

A polysilicon-insulator-polysilicon (PIP) capacitor is a parasitic capacitance device provided by a floating-gate memory process platform, in which a capacitor corresponding to an inter-gate dielectric layer of a floating-gate memory and a capacitor corresponding to a tunneling oxide layer are connected in parallel to provide a capacitance device with a high capacitance efficiency. PIP capacitors can be used in charge pump boost circuits or filter circuits.

Generally, a PIP capacitor is of a flat structure having advantages of a simple structure and a relatively simple manufacturing process. However, the flat structure has a large overall area. Thus, in the manufacturing process, a large recess may be easily generated in the flat structure subjected to a chemical mechanical polishing process, so that the thickness of the floating-gate may be reduced. This may significantly affect the subsequent processes of the floating-gate and, in a severe case, easily cause reliability problems of the capacitor.

### SUMMARY

According to some embodiments of the present disclosure, a semiconductor device includes: a substrate having a capacitance region; a plurality of first electrode structures disposed on a surface of the substrate in the capacitance region and arranged at intervals in a first direction parallel to the substrate surface; a second electrode structure disposed on side surfaces and a top surface of each of the first electrode structures; and a first dielectric layer disposed between the second electrode structure and each of the first electrode structures.

According to some embodiments of the present disclosure, a method of forming a semiconductor device includes: forming a substrate having a capacitor region; forming a plurality of first electrode structures on a surface of the substrate in the capacitor region, where the first electrode structures are arranged at intervals in a first direction parallel to the surface of the substrate; forming a first dielectric layer on side surfaces and a top surface of each of the first electrode structures; and forming a second electrode structure on a surface of the first dielectric layer, where the first dielectric layer is disposed between the second electrode structure and each of the first electrode structures.

### DESCRIPTION OF THE DRAWINGS

FIG. 1 is a schematic cross-sectional view of a semiconductor device in the related art.
FIG. 2 is a schematic top view of a semiconductor device according to some embodiments of the present disclosure.
FIG. 3 schematically shows a cross-section of the semiconductor device taken along line A-A1 in FIG. 2.
FIG. 4 schematically shows a cross-section of the semiconductor device taken along line C-C1 in FIG. 2.
FIG. 5 schematically shows a cross-section of the semiconductor device taken along line B-B1 in FIG. 2.
FIG. 6 is a schematic top view of a semiconductor device according to some embodiments of the present disclosure.
FIG. 7 is a schematic top view of a semiconductor device according to some embodiments of the present disclosure.
FIG. 8 is a schematic top view of a semiconductor device according to some embodiments of the present disclosure.
FIG. 9 is a schematic top view of a semiconductor device according to some embodiments of the present disclosure.
FIG. 10 is a schematic flowchart of a method of manufacturing a semiconductor device according to some embodiments of the present disclosure.
FIGS. 11 to 17 schematically illustrate respective structures obtained during a process of forming a semiconductor device according to some embodiments of the present disclosure.

### DETAILED DESCRIPTION

Some embodiments of the present disclosure will be described in detail below with reference to the accompanying drawings. The embodiments are described for illustrative purposes only and are not intended to limit the present disclosure.

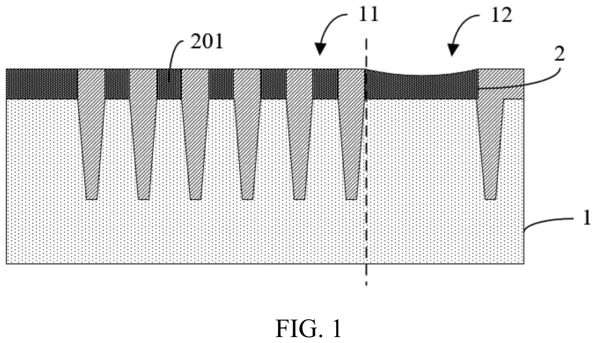

FIG. 1 is a schematic diagram of a cross-sectional structure of a semiconductor device in the related art. It should be noted that, in order to show the effect of the chemical mechanical polishing process on the floating-gate structure, a control gate structure and a dielectric layer between the floating-gate structure and the control gate structure are not shown.

The semiconductor device includes a substrate 1, a floating-gate structure 2 located on the substrate 1, a dielectric layer (not shown) located on the floating-gate structure 2, and a control gate structure (not shown) located on the dielectric layer. The substrate 1 includes a storage array region 11 and a capacitor region 12. The floating-gate structure 2 includes a plurality of mutually discrete floating-gates 201 in the storage array region 11. The floating-gate structure 2 is a full block in the capacitor region 12, and the control gate structure is a full block in the storage array region 11 and the capacitor region 12. A capacitor is constituted of the floating-gate structure 2, the dielectric layer and the control gate structure in the capacitor region 12, and the floating-gate 201 of the capacitor region 12 is a full block, that is, a flat structure.

Since there is a larger pattern density difference between the floating-gate structure 2 of the capacitor region 12 and the floating-gate 201 of the storage array region 11, it is easy to generate a larger recess in the floating-gate structure 2 of the capacitor region 12 after the chemical mechanical polishing process for forming the floating-gate structure 2 is performed, which causes the thickness of the floating-gate structure 2 to be thinned, has a great influence on the subsequent process, and causes a capacitor reliability problem when it is serious. In addition, a capacitance value of such a plate capacitor is limited by a contact area of the capacitor, so that it is difficult to increase the capacitance value.

For the above reasons, some embodiments of the present disclosure provide a semiconductor device, including: a substrate having a capacitor region; a plurality of first electrode structures located on a surface of the substrate in the capacitor region, the plurality of first electrode structures arranged in a first direction parallel to the surface of the substrate; a second electrode structure located on side surfaces and a top surface of each of the plurality of first electrode structures; and a first dielectric layer between the second electrode structure and each of the first electrode structures.

By providing the plurality of first electrode structures spaced apart from each other, it is possible to reduce a recessing phenomenon due to a larger area of the first electrode structure in the flat structure in the process and improve reliability of the device. Further, since a capacitor may be formed between the second electrode structure and the top surface and the two sides of the first electrode structure, a surface area (especially the area of the sides) of the first electrode structure is fully utilized, and a capacitance area is increased relative to the flat structure, thereby increasing the capacitance value without increasing the area of the device.

The semiconductor device according to the embodiments of the present disclosure is described below with reference to the accompanying drawings.

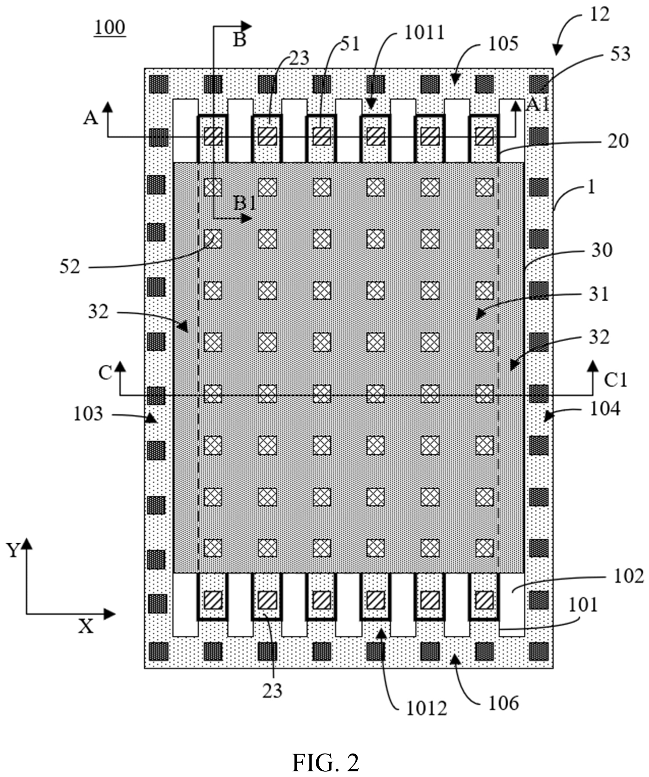

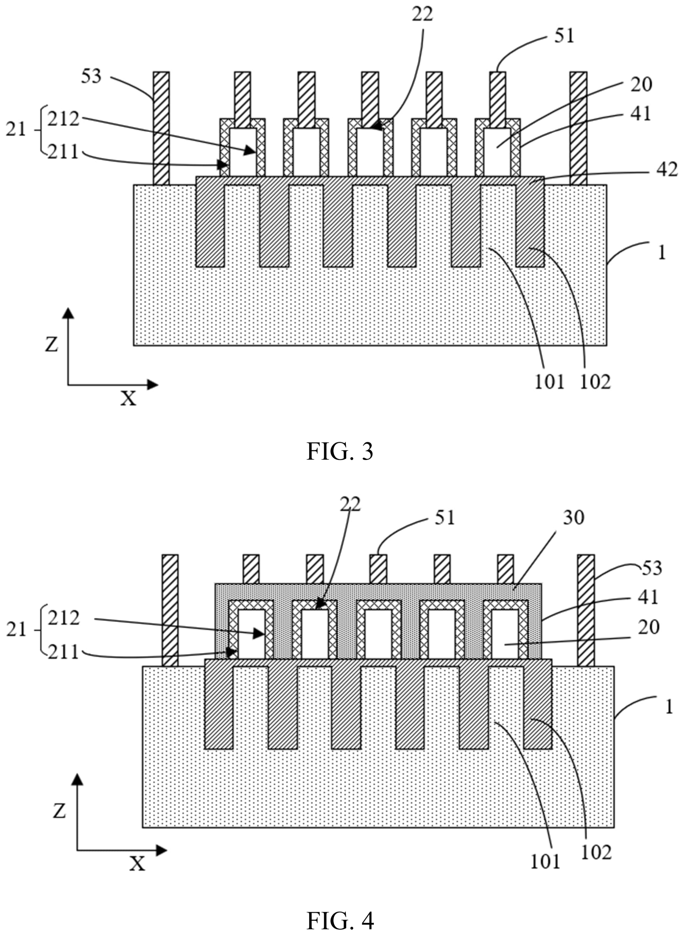

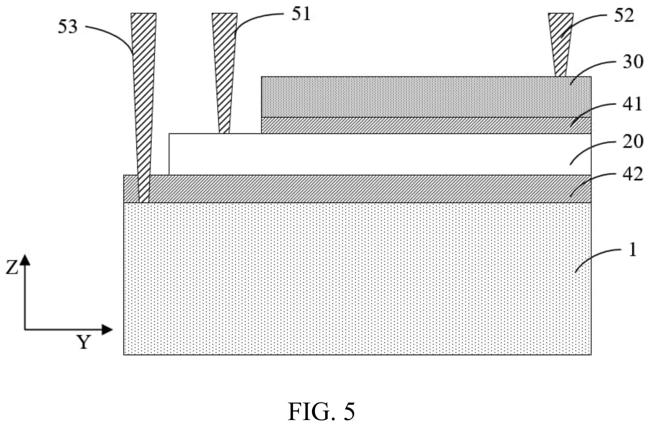

FIG. 2 is a schematical top view of a semiconductor device according to some embodiments of the present disclosure. FIG. 3 schematically shows a cross-section of the semiconductor device taken along line A-A1 in FIG. 2, FIG. 4 schematically shows a cross-section of the semiconductor device taken along line C-C1 in FIG. 2, and FIG. 5 schematically shows a cross-section of the semiconductor device taken along line B-B1 in FIG. 2.

In the drawings, the third direction Z is perpendicular to the first direction X and the second direction Y and is used to indicate a direction perpendicular to the surface of the substrate of the semiconductor device.

The semiconductor device 100 includes a substrate 1, a plurality of first electrode structures 20, a second electrode structure 30, and a first dielectric layer 41. The substrate 1 includes a capacitor region 12, where the plurality of first electrode structures 20 are located on a surface of the substrate 1 in the capacitor region 12, and the plurality of first electrode structures 20 are arranged in the first direction X parallel to the surface of the substrate 1. The second electrode structure 30 is located on side surfaces 21 and a top surface 22 of each of the plurality of first electrode structures 20, and the first dielectric layer 41 is between the second electrode structure 30 and each of the first electrode structure 20.

It should be understood that, since the second electrode structure 30 is located on the side surface 21 and the top surface 22 of the first electrode structure 20 and the first dielectric layer 41 isolates the first electrode structure 20 from the second electrode structure 30, the first dielectric layer 41 is also located on the side surface 21 and the top surface 22 of the first electrode structure 20. "Top surface 22" refers to a surface of the first electrode structure 20 away from the substrate 1, and "side surface 21" refers to a surface of the first electrode structure 20 perpendicular to the substrate 1.

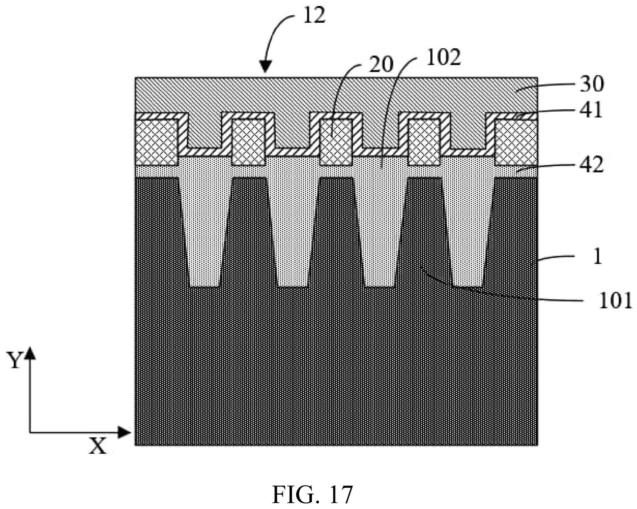

In some embodiments, the first dielectric layers 41 located on the surfaces of the first electrode structures adjacent to each other may be connected to each other, as shown in FIG. 17.

A capacitor is constituted of the first electrode structure 20, the first dielectric layer 41 and the second electrode structure 30, and opposite areas of the capacitor include an area of the side surface 21 and an area of the top surface 22 of the first electrode structure 20. That is, the capacitor utilizes the side surface 21 and the top surface 22 of the first electrode structure 20.

In some embodiments, materials of the first electrode structures 20 and the second electrode structure 30 may each include polysilicon, the first dielectric layer 41 may include a silicon oxide layer or a silicon nitride layer, and the first dielectric layer 41 may further include a silicon oxide layer, a silicon nitride layer, and a silicon oxide layer stacked sequentially.

As shown in FIG. 2, an extension direction of each of the plurality of the first electrode structures 20 is parallel to the second direction Y, that is, the first electrode structures 20 extend in the second direction Y. The second direction Y is parallel to the surface of the substrate 1, and the second direction Y is different from the first direction X. For example, the first direction X may be perpendicular to the second direction Y, or may be intersected with the second direction Y at an angle.

As shown in FIGS. 2 to 4, the side surfaces of the each of the first electrode structures 20 includes a first side surface 211 and a second side surface 212 opposite to each other in the first direction X, and the second electrode structure 30 is located on the first side surface 211 and the second side surface 212. That is, the second electrode structure 30 may cover the first side surface 211 and the second side surface 212 of the first electrode structure 20.

The semiconductor device 100 may further include a plurality of first contact structures 51 each extending in a direction perpendicular to the surface of the substrate 1 (i.e., the Z direction) and electrically connected to respective one of the first electrode structures 20.

In some embodiments, each of the first electrode structure 20 extends beyond the second electrode structure 30 in the second direction Y, the first dielectric layer 41 may also extend beyond the second electrode structure 30 in the second direction Y, each of the first contact structures 51 may extend through the first dielectric layer 41 in the third direction Z, and a bottom portion of the first contact structure 51 is connected to respective one of the first electrode structures 20.

In some embodiments, each of the first electrode structures 20 may include two ends 23 opposite to each other in the second direction Y, the second electrode structure 30 exposes the ends 23, and each of the first contact structure 51 is connected to at least one of the ends 23 of the respective one of the first electrode structures 20.

As shown in FIG. 2, the first contact structure 51 is connected to the two ends 23.

The semiconductor device 100 may further include one or more second contact structures 52 electrically connected to the second electrode structure 30, where each of the second contact structures 52 is configured to apply a voltage to the second electrode structure 30.

In some embodiments, the second electrode structure 30 includes a first region 31 and second regions 32 located respectively on opposite sides of the first region 31 in the first direction X. The second contact structures 52 are evenly distributed in the first region 31 or the second regions 32.

As shown in FIG. 2, the second contact structures 52 are evenly distributed in the first region 31.

In some embodiments, as shown in FIGS. 3 and 4, the substrate 1 includes a plurality of active portions 101 and a plurality of isolation structures 102, where the each of the isolation structures 102 is located between two adjacent ones of the active portions 101, each of the active portions 101 extends in a direction parallel to the second direction Y and are arranged in the first direction X, and the first electrode structures 20 are opposite respectively to the active portions 101. That is, each of the first electrode structures 20 corresponds to respective one of the active portions 101, and a spacing region between two adjacent ones of the first electrode structures 20 corresponds to respective one of the isolation structures 102.

In some embodiments, the second electrode structure 30 extends beyond the active portions 101 in the first direction X and the second electrode structure 30 extends beyond the first electrode structures 20 in the first direction X, so that the second electrode structure 30 can cover the first side surface 211 and the second side surface 212 of each of the first electrode structures 20.

The semiconductor device 100 may further include a second dielectric layer 42 between the first electrode structures 20 and the active portions 101, so that another capacitor may be formed between the first electrode structures 20, the second dielectric layer 42, and the active portions 101 of the substrate 1.

In some embodiments, each of the isolation structures 102 may extend in the first direction X and further extend between two ones of the first electrode structures 20 adjacent to the isolation structure 102, thereby improving the isolation effect of the two first electrode structures 20 adjacent to the isolation structure 102. As shown in FIGS. 3 and 4, the isolation structure 102 is also located between adjacent second dielectric layers 42, and an upper surface of the isolation structure 102 is higher than an upper surface of each of the second dielectric layers 42.

In some embodiments, each of the active portions 101 includes a first end 1011 and a second end 1012 opposite to each other in the second direction Y, at least one of the first end 1011 and the second end 1012 extending beyond the first electrode structures 20 in the second direction Y. That is, the first electrode structures 20 expose at least one of the first end 1011 and the second end 1012.

As shown in FIG. 2, the first electrode structures 20 expose the first end 1011 and the second end 1012.

The semiconductor device 100 may further include a third contact structure 53 connected to the substrate 1, where the third contact structure 53 is located in at least one of the first end 1011 and the second end 1012. In other words, the third contact structure 53 may be located in the first end 1011 or the second end 1012, or may be located in both the first end 1011 and the second end 1012.

In some embodiments, as shown in FIG. 2, the substrate 1 may include a third end 103 and a fourth end 104 extending in the first direction X on both sides of the second electrode structure 30, and the third contact structure 53 is further located in the third end 103 and the fourth end 104. In other words, the third contact structure 53 is provided around the first electrode structures 20 and the second electrode structure 30 in a top view direction.

In some embodiments, the substrate 1 further includes a first connection portion 105 that connects a plurality of first ends 1011 in the first direction X, that is, the same ends of the plurality of active portions 101 are connected by the first connection portion 105.

In some embodiments, the substrate 1 further includes a second connection portion 106 that connects a plurality of second ends 1012 in the first direction X, i.e. the other ends of the plurality of active portions 101 are connected by the second connection portion 106.

In some embodiments, the substrate 1 may further include a storage array region (not shown).

The semiconductor device 100 may further include a storage structure (not shown) located on the surface of the substrate 1 in the storage array region, where the storage structure includes a floating-gate structure, a control gate structure, and a storage layer located between the floating-gate structure and the control gate structure. Where the floating-gate structure is provided in the same layer as the first electrode structure 20, the storage layer is provided in the same layer as the first dielectric layer 41, and the control gate structure is provided in the same layer as the second electrode structure 30.

The floating-gate structure may be the same as the structure of the first electrode structure 20, the control gate structure may be the same as the structure of the second electrode structure 30, and the storage layer may be the same as the structure of the first dielectric layer 41. Where a plurality of floating-gate structures are spaced apart from each other and arranged in the first direction X, the control gate structure is located on side surfaces and a top surface of each of the plurality of the floating-gate structures, and the storage layer is located between the control gate structure and the floating-gate structure.

The semiconductor device 100 may further include a tunneling layer (not shown) located between the floating-gate structure and the substrate 1. Where the tunneling layer may be provided in the same layer as the second dielectric layer 42.

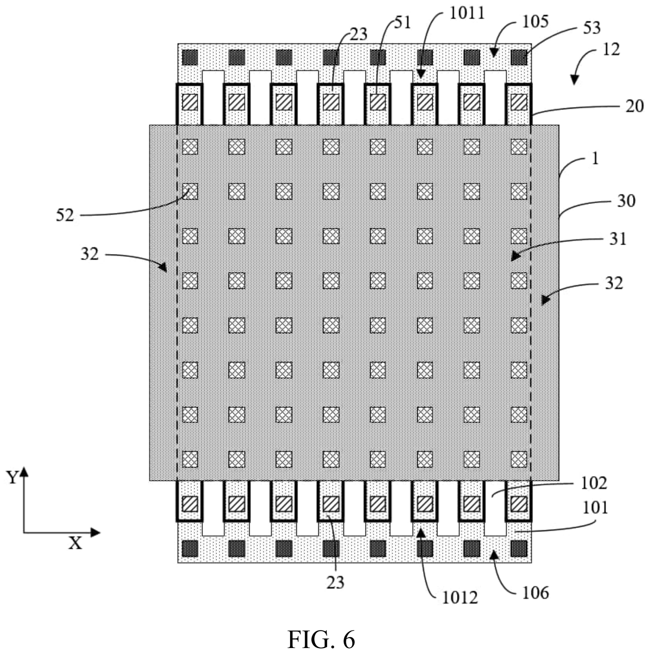

Please refer to FIG. 6, which is a schematic top view of a semiconductor device according to some embodiments of the present disclosure, and mainly shows a layout of the first electrode structures 20, the second electrode structure 30, the first contact structures 51, the second contact structures 52, and the third contact structures 53.

The embodiment of FIG. 6 differs from the embodiment of FIG. 2 described above in that the third contact structure 53 is located only in the first end 1011 and the second end 1012 of the active portion 101.

It should be understood that FIG. 6 shows only the active portion 101 and the isolation structure 102 of the substrate 1, while other portions of the substrate 1 are omitted. A portion of the second electrode structure 30 extending beyond the active portion 101 in the first direction X in the embodiment of FIG. 6 is located on the surface of the other portion of the substrate 1, i.e., left and right sides of the second electrode structure 30 are not suspended. In some embodiments, a material of the active portion 101 of the substrate 1 is the same as that of other portions of the substrate 1.

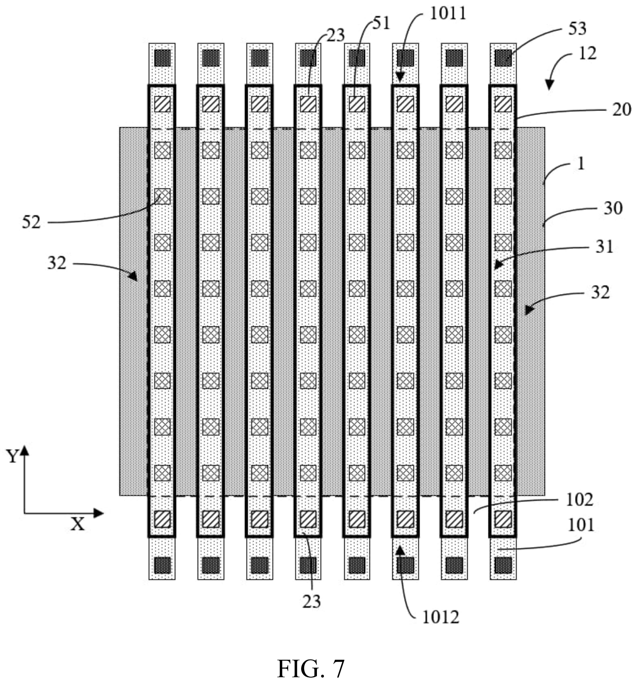

Please refer to FIG. 7, which is a schematic top view of a semiconductor device according to some embodiments of the present disclosure, and mainly shows a layout of the first electrode structures 20, the second electrode structure 30, the first contact structures 51, the second contact structures 52, and the third contact structures 53.

The embodiment of FIG. 7 differs from the embodiment of FIG. 6 described above in that the substrate 1 does not include the first connection portion 105 and the second connection portion 106, i.e., the ends of the active portions 101 are not interconnected with each other.

In some embodiments, the substrate 1 may include the first connection portion 105 and not include the second connection portion 106; and alternatively, the substrate 1 includes the second connection portion 106 and does not includes the first connection portion 105.

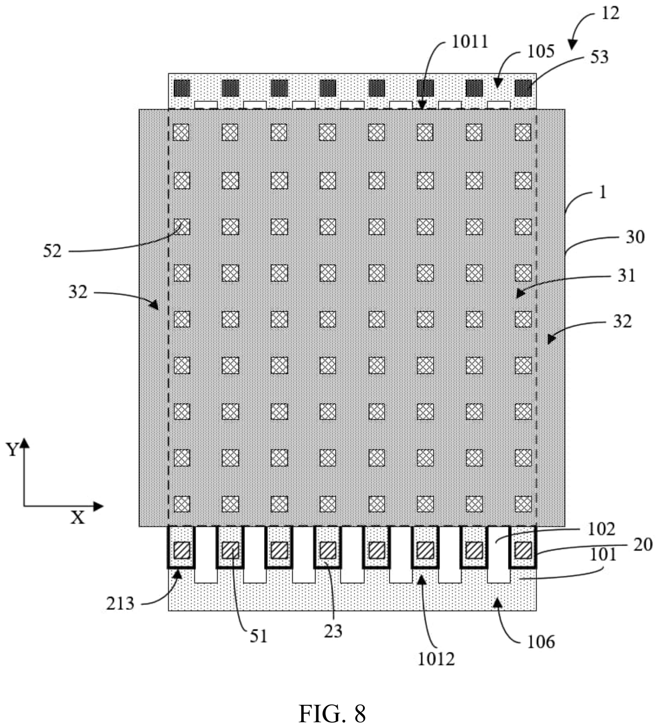

Please refer to FIG. 8, which is a schematic top view of a semiconductor device according to some embodiments of the present disclosure, and mainly shows a layout of the first electrode structures 20, the second electrode structure 30, the first contact structures 51, the second contact structures 52, and the third contact structures 53.

The embodiment of FIG. 8 differs from the embodiment of FIG. 6 described above in that the side surfaces of the first electrode structure 20 further includes a third side surface 213 and a fourth side surface (not shown) opposite to each other in the second direction Y, and the second electrode structure 30 is also located on the third side surface 213 and/or the fourth side surface.

In some examples, the second electrode structure 30 may be located on the first side surface 211, the second side surface 212, and the third side surface 213 of the first electrode structure 20, or located on the first side surface 211, the second side surface 212, and the fourth side surface of the first electrode structure 20, or located on the first side surface 211, the second side surface 212, the third side surface 213, and the fourth side surface of the first electrode structure 20.

As shown in FIG. 8, the second electrode structure 30 may be located on the first side surface 211, the second side surface 212, and the fourth side surface of the first electrode structure 20.

In some embodiments, the first contact structure 51 is connected to one end 23 of the first electrode structure 20 (one end 23 of the first electrode structure 20 close to the third side surface 213), that is, the first contact structure 51 is located at only one end of the first electrode structure 20.

In some embodiments, the first contact structure 51 may also be connected to one end of the first electrode structure 20 close to the fourth side surface of the first electrode structure 20. Since the second electrode structure 30 covers one end of the first electrode structure 20 close to the fourth side surface, the first contact structure 51 close to the fourth side surface may extend through the second electrode structure 30 and the first dielectric layer 41 in the third direction Z and be electrically isolated from the second electrode structure 30.

In some embodiments, the second electrode structure 30 is located on the first side surface 211, the second side surface 212, the third side surface 213, and the fourth side surface of the first electrode structure 20, and the first contact structure 51 extends through the second electrode structure 30 and the first dielectric layer 41 in the third direction Z and is electrically isolated from the second electrode structure 30.

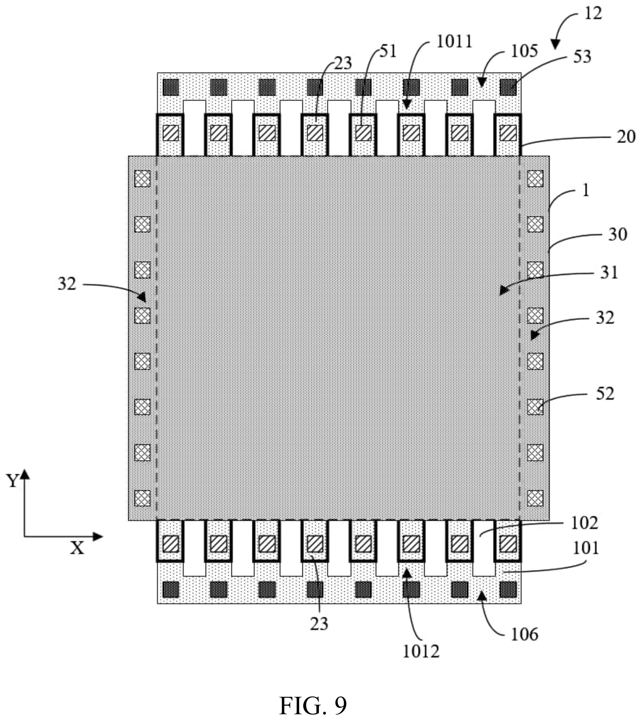

Please refer to FIG. 9, which is a schematic top view of a semiconductor device according to some embodiments of the present disclosure, and mainly shows a layout of the first electrode structures 20, the second electrode structure 30, the first contact structures 51, the second contact structures 52, and the third contact structures 53.

The embodiment of FIG. 9 differs from the embodiment of FIG. 6 described above in that the second contact structure 52 is located on the surface of the second electrode structure 30 in the second region 32.

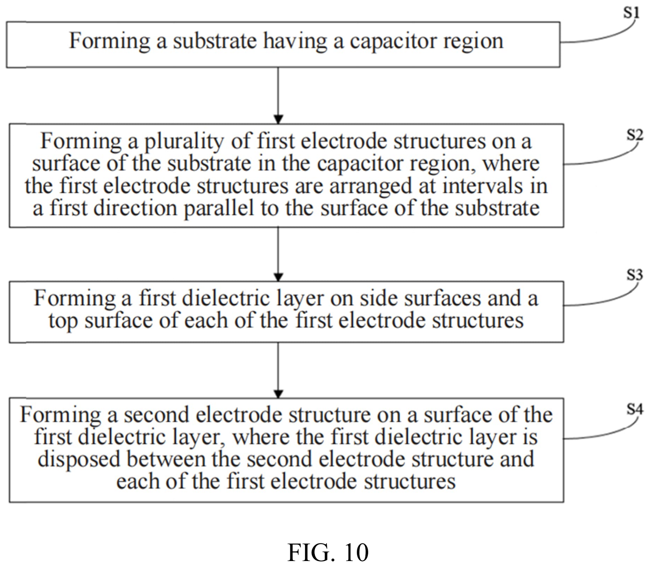

Accordingly, embodiments of the present disclosure further provide a method of manufacturing the semiconductor device according to any one of the above embodiments. Please refer to FIG. 10, which is a schematic flowchart of a method of manufacturing a semiconductor device according to some embodiments of the present disclosure. The method includes following steps S1-S4.

At the step S1, a substrate including a capacitor region is formed.

At the step S2, a plurality of first electrode structures are formed on a surface of the substrate in the capacitor region, where the plurality of first electrode structures are spaced apart from each other and arranged in a first direction, and the first direction is parallel to the surface of the substrate.

At the step S3, a first dielectric layer is formed on side surface and a top surface of each of the plurality of first electrode structures.

At the step S4, a second electrode structure is formed on a surface of the first dielectric layer, where the first dielectric layer is located between the second electrode structure and the first electrode structure.

The semiconductor device in any one of the above-described embodiments can be formed by the method. By forming the plurality of first electrode structures spaced apart from each other, it is possible to reduce a recessing phenomenon due to a larger area of the first electrode structure in the flat structure in the process and improve reliability of the device. Further, since a capacitor may be formed between the second electrode structure and the top surface and the two side surfaces of the first electrode structure, a surface area (especially the area of the side surface) of the first electrode structure is fully utilized, and a capacitance area is increased relative to the flat structure, thereby increasing the capacitance value without increasing the area of the device.

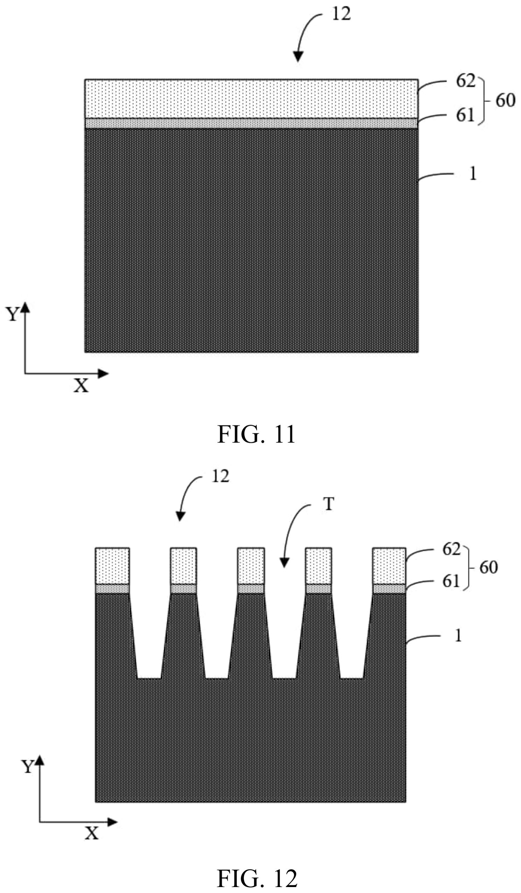

The method of forming the semiconductor device will be described with reference to FIGS. 11 to 17, which schematically illustrate respective structures obtained during a process of forming a semiconductor device according to some embodiments of the present disclosure.

At the step S1, a substrate 1 including a capacitor region 12 is formed, seeing FIG. 11.

The substrate 1 may include a storage array region (not shown) and a capacitor region 12, where the storage array region is used to form a storage structure, and the capacitor region 12 is used to form a capacitor.

After the substrate 1 is formed, the method further includes following processes, seeing FIGS. 11 to 13.

A mask layer 60 is formed on the substrate 1, seeing FIG. 11. The process of forming the mask layer 60 may include a deposition process, and the material of the mask layer 60 may include a silicon oxide layer 61 and a silicon nitride layer 62 stacked sequentially.

One or more trenches T for penetrating both the mask layer 60 and the substrate 1 are formed, seeing FIG. 12. The process of forming the trenches T may include a dry etching process.

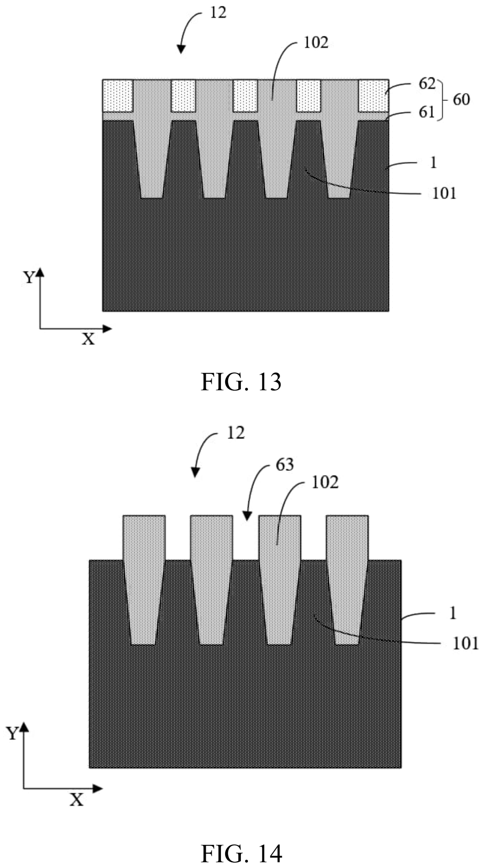

An isolation structure 102 is formed in each of the trenches T, seeing FIG. 13.

The method of forming the isolation structure 102 may include: forming an isolation material layer within each of the trenches T and on the surface of the mask layer 60; and performing a planarization process on the isolation material layer, until the surface of the mask layer 60 is exposed. The process of forming the isolation material layer may include a deposition process, the material of the isolation material layer may include silicon oxide, and the planarization process may include a chemical mechanical polishing process. Where, an active portion 101 is formed between two adjacent isolation structures 102.

At the step S2, a plurality of first electrode structures 20 are formed on a surface of the substrate 1 in the capacitor region 12, where the plurality of first electrode structures 20 are spaced apart from each other and arranged in a first direction X, and the first direction X is parallel to the surface of the substrate 1, seeing FIGS. 14 to 15.

After the isolation structure 102 is formed, the mask layer 60 is removed to form a first groove 63 between two adjacent ones of the isolation structures 102, seeing FIG. 14. The process of removing the mask layer 60 includes a wet etching process.

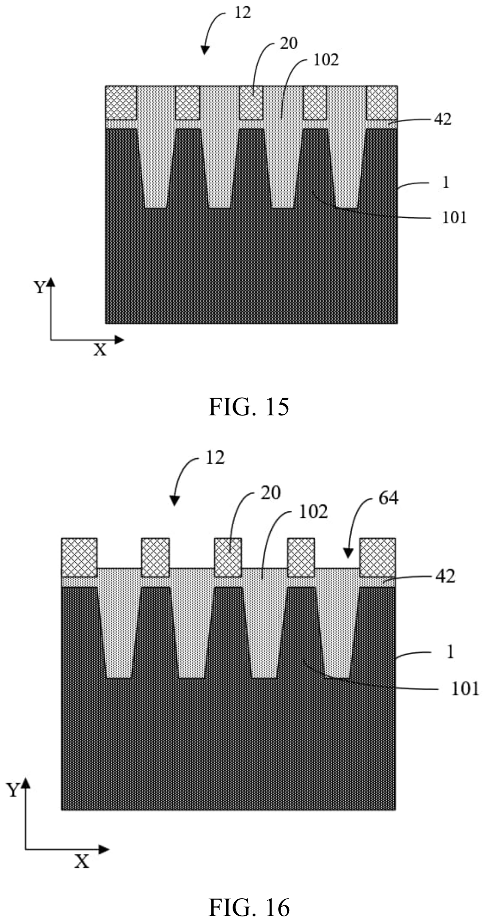

Respective one of the first electrode structures 20 is formed within the first groove 63, seeing FIG. 15.

The method of forming the first electrode structures 20 may include: forming a first electrode material layer within the first groove 63 on the surface of the isolation structure 102; and performing a planarization process on the first electrode material layer until the isolation structure 102 is exposed.

The process of forming the first electrode material layer includes one of various deposition processes and an etching process, the material of the first electrode material layer may include polysilicon, and the planarization process includes a chemical mechanical polishing process. The etching process may be performed according to a desired pattern of the first electrode structures 20 in a top view provided in any of the above embodiments.

The method of forming the semiconductor device may further include: forming a plurality of floating-gate structures on the surface of the substrate 1 in the storage array region in the process of forming the plurality of first electrode structures 20.

In some embodiments, before the first electrode structure 20 is formed within the first groove 63, a second dielectric layer 42 is formed at a bottom portion of the first groove 63.

In some embodiments, the method of forming the second dielectric layer 42 includes: forming a second dielectric material layer at the bottom portion and the side surface of the first groove 63, where the second dielectric material layer at the bottom portion of the first groove 63 is used to form the second dielectric layer 42, and the second dielectric material layer at the side surface of the first groove 63 may be used as a portion of the isolation structure 102. The process of forming the second dielectric material layer includes a deposition process, and the material of the second dielectric material layer may include silicon oxide.

At the step S3, a first dielectric layer 41 is formed on side surfaces 21 and a top surface 22 of each of the plurality of first electrode structures 20, seeing FIGS. 16 to 17.

A portion of the isolation structure 102 between adjacent first electrode structures 20 is removed to form a second groove 64, seeing FIG. 16. The process of removing the portions of the isolation structure 102 includes a wet etching process, and a bottom surface of the second groove 64 may be higher than a top surface of the second dielectric layer 42.

The first dielectric layer 41 is formed on an inner wall of the second groove 64 and the surface of the first electrode structure 20, seeing FIG. 17. The process of forming the first dielectric layer 41 may include a deposition process, and the first dielectric layer 41 may include a silicon oxide layer 61 or a silicon nitride layer 62, or include a silicon oxide layer 61, a silicon nitride layer 62, and a silicon oxide layer 61 stacked sequentially.

The method of forming the semiconductor device may further include: forming a storage layer located on side surfaces 21 and a top surface 22 of the floating-gate structure in the process of forming the first dielectric layer 41.

At the step S4, a second electrode structure 30 is formed on a surface of the first dielectric layer 41, where the first dielectric layer 41 is located between the second electrode structure 30 and the first electrode structure 20, seeing to FIG. 17.

In some embodiments, in the process of forming the second electrode structure 30, a portion of the second electrode structure 30 fills a spacing between adjacent first electrode structures 20.

The method of forming the second electrode structure 30 includes: forming a second electrode material layer on a surface of the first dielectric layer 41; and etching the second electrode material layer to form the second electrode structure 30. The material of the second electrode material layer may include polysilicon, and the etching process may be performed according to a desired pattern of the second electrode structure 30 in the top view provided in any of the above embodiments.

The method of forming the semiconductor device may further include: forming a control gate structure on a surface of the storage layer in the process of forming the second electrode structure 30, where the storage layer is located between the floating-gate structure and the control gate structure.

Therefore, the method of forming the semiconductor device in the embodiments of the present disclosure can be compatible with the process of the storage structure and the capacitor, and can solve the recess problem of the first electrode structure 20 and increase the capacitance value of the capacitor.

Referring to FIG. 2, the method of forming the semiconductor device may further include: forming one or more first contact structures 51 each electrically connected to respective one of the first electrode structures 20; forming one or more second contact structures 52 electrically connected to the second electrode structure 30; and forming one or more third contact structures 53 electrically connected to the substrate 1. A material of the contact structure may include tungsten, and the process of forming the contact structure may include an etching process and a deposition process, which are not repeatedly described herein.

In the description of the present disclosure, the term "first", "second", or the like are for illustrative purposes only and are not to be construed as indicating or imposing a relative importance or implicitly indicating the number of technical features indicated. Thus, a feature that limited by "first", "second" may expressly or implicitly include at least one of the features. In the description of the present application, "a plurality of" means two or more, unless otherwise specifically defined.

In the above, the description of each embodiment has its own emphasis. For a part of an embodiment that is not described in detail, the relevant description of other embodiments may be referred to.

Some embodiments of the present disclosure have been described in detail above. Many modifications or equivalent substitutions with respect to the embodiments may occur to those of ordinary skill in the art based on the present disclosure. Thus, these modifications or equivalent substitutions shall fall within the scope of the present disclosure.

## Claims

1. A semiconductor device (100), comprising:
a substrate (1) having a capacitor region (12);
a plurality of first electrode structures (20) disposed on a surface of the substrate (1) in the capacitor region (12) and arranged at intervals in a first direction (X) parallel to the surface of the substrate (1);
a second electrode structure (30) disposed on side surfaces (21) and a top surface (22) of each of the first electrode structures (20); and
a first dielectric layer (41) disposed between the second electrode structure (30) and each of the first electrode structures (20).

2. The semiconductor device (100) of claim 1, wherein each of the first electrode structures (20) extends in a second direction (Y) parallel to the surface of the substrate (1) and different from the first direction (X).

3. The semiconductor device (100) of claim 2, wherein the side surfaces (21) comprise a first side surface (211) and a second side surface (212) opposite to each other in the first direction (X).

4. The semiconductor device (100) of claim 3, wherein the side surfaces (21) further comprise a third side surface (213) and a fourth side surface opposite to each other in the second direction (Y), and the second electrode structure (30) is further disposed on at least one of the third side surface (213) or the fourth side surface.

5. The semiconductor device (100) of claim 2, further comprising:
a plurality of first contact structures (51), each extending in a direction perpendicular to the surface of the substrate (1) and electrically connected to one of the first electrode structures (20).

6. The semiconductor device (100) of claim 5, wherein each of the first electrode structures (20) has two ends (23) opposite to each other in the second direction (Y); and
each of the first contact structures (51) is electrically connected to at least one of the two ends (23) of one of the first electrode structures (20).

7. The semiconductor device (100) of claim 1, further comprising: a plurality of second contact structures (52) each electrically connected to the second electrode structure (30).

8. The semiconductor device (100) of claim 7, wherein the second electrode structure (30) has a first region (31), and second regions (32) located respectively on opposite sides of the first region (31) in the first direction (X); and
the second contact structures (52) are evenly distributed in the first region (31) or the second regions (32).

9. The semiconductor device (100) of claim 2, wherein the substrate (1) comprises a plurality of active portions (101) and a plurality of isolation structures (102), each of the isolation structures (102) being located between two adjacent ones of the active portions (101);
each of the active portions (101) extends in the second direction (Y), and the active portions (101) are arranged in the first direction (X); and
the first electrode structures (20) are opposite respectively to the active portions (101).

10. The semiconductor device (100) of claim 9, wherein each of the active portions (101) has a first end (1011) and a second end (1012) opposite to each other in the second direction (Y); and
at least one of the first end (1011) or the second end (1012) extends beyond one of the first electrode structures (20) in the second direction (Y).

11. The semiconductor device (100) of claim 10, further comprising:
a third contact structure (53) disposed opposite to the at least one of the first end (1011) or the second end (1012).

12. The semiconductor device (100) of claim 10, wherein the substrate (1) further comprises:
a first connection portion (105) connecting the first end (1011) of each of the active portions (101) in the first direction (X).

13. The semiconductor device (100) of claim 10, wherein the substrate (1) further comprises:
a second connection portion (106) connecting the second end (1012) of each of the active portions (101) in the first direction (X).

14. The semiconductor device (100) of claim 9, further comprising: a second dielectric layer (42) disposed between the first electrode structures (20) and the active portions (101).

15. A method of forming a semiconductor device (100), comprising:
forming a substrate (1) having a capacitor region (12);
forming a plurality of first electrode structures (20) on a surface of the substrate (1) in the capacitor region (12), wherein the first electrode structures (20) are arranged at intervals in a first direction (X) parallel to the surface of the substrate (1);
forming a first dielectric layer (41) on side surfaces (21) and a top surface (22) of each of the first electrode structures (20); and
forming a second electrode structure (30) on a surface of the first dielectric layer (41), wherein the first dielectric layer (41) is disposed between the second electrode structure (30) and each of the first electrode structures (20).
